(19) Europäisches Patentamt
European Patent Office
Office européen des brevets

(11) EP 1 197 517 A1

(12) EUROPEAN PATENT APPLICATION
published in accordance with Art. 158(3) EPC

(43) Date of publication:
**17.04.2002 Bulletin 2002/16**

(21) Application number: **00900155.3**

(22) Date of filing: **11.01.2000**

(51) Int Cl.⁷: **C08L 21/00**, C08L 83/04, C08L 15/02, C08L 27/12, C08K 3/22, C08K 3/36, H01L 23/29

(86) International application number:
**PCT/JP00/00055**

(87) International publication number:
**WO 00/42100 (20.07.2000 Gazette 2000/29)**

(84) Designated Contracting States:
**AT BE CH CY DE DK ES FI FR GB GR IE IT LI LU MC NL PT SE**

(30) Priority: **12.01.1999 JP 586299**

(71) Applicant: **Daikin Industries, Ltd.**
**Osaka-shi, Osaka 530-8323 (JP)**

(72) Inventors:
- **TANAKA, Hiroyuki, Yodogawa-seisakusho Settsu-shi, Osaka 566-8585 (JP)**
- **HASEGAWA, Masanori, Yodogawa-seisakusho Settsu-shi, Osaka 566-8585 (JP)**
- **NOGUCHI, Tsuyoshi, Yodogawa-seisakusho Settsu-shi, 0saka566-8 585 (JP)**
- **HIGASHINO, Katsuhiko, Yodogawa-seisakusho Settsu-shi, Osaka 566-8585 (JP)**

(74) Representative: **HOFFMANN - EITLE**
**Patent- und Rechtsanwälte**
**Arabellastrasse 4**
**81925 München (DE)**

# (54) CROSSLINKABLE ELASTOMER COMPOSITION AND FORMED ARTICLE PREPARED FROM SAID COMPOSITION

(57) To provide a very clean elastomer molded article excellent in plasma resistance, having excellent property of metal-elution inhibition and is used suitably as a material for molded article for a semiconductor or liquid crystal manufacturing equipment. The molded article is obtained by crosslinking a crosslinkable elastomer composition comprising an elastomer component and a metal oxide filler comprising a silicon oxide filler containing impurity metals other than silicon in an amount of not more than 100 ppm. The molded article has an impurity metal content of not more than 100 ppm, and an increasing rate of particles generated by irradiating oxygen plasma to the article is not more than 1,000 % or an amount of impurity metals other than silicon which is extracted with a 50 % aqueous solution of HF is not more than 200 ppb.

EP 1 197 517 A1

## Description

### TECHNICAL FIELD

The present invention relates to a clean crosslinkable elastomer composition which can give a molded article to be used for a semiconductor manufacturing equipment, for example, a sealing member to be used for sealing of the semiconductor manufacturing equipment, and relates to a molded article which is obtained from the composition, is excellent in plasma resistance, has an excellent property of inhibiting elution of metals and has a reduced content of impurity metals.

### BACKGROUND ART

In manufacturing semiconductor elements, very high cleanliness is required, and the requirements for high cleanliness range over not only management of a production process of semiconductors but also a semiconductor manufacturing equipment itself and parts of such equipment. Even if the parts of semiconductor manufacturing equipment are cleaned after built in the equipment, a degree of possible cleanliness is limited. Such parts are required to have been cleaned highly before built in the equipment. Contamination which becomes a problem particularly in the production of semiconductors is caused by fine particles, organic compounds and elution of metals which have an adverse effect on accurate etching treatment.

Also high cleanliness is required similarly in a molded article such as a sealing member for semiconductor manufacturing equipment which the present invention can be particularly suitably applied to. The present applicants have attained high cleanliness of the sealing member itself by employing a special method of cleaning the sealing member after molding (WO99/49997).

Such a sealing member is produced by crosslinking a crosslinkable elastomer composition such as a rubber, and in order to provide the sealing member with mechanical properties, there is a case where a metal oxide filler such as a titanium oxide or silicon oxide is added to the composition.

Also in production of semiconductors, there is a case where a dry process such as oxygen plasma ashing is carried out. In that dry process, there is a case where particles (impurity fine particles) are generated from a molded article produced from an elastomer. Those contaminating sources must be eliminated.

Further in production of semiconductors, besides the dry process, there is a wet process employing ultrapure water, hydrochloric acid, and the like. In that wet process, it is necessary to lower elution of impurity metals approximately to zero.

An object of the present invention is to provide a crosslinkable elastomer composition containing a metal oxide filler which has a reduced content of impurity metals, is excellent in plasma resistance and has an excellent property of metal-elution inhibition.

Further the present invention relates to a molded article which can be obtained by crosslinking the above-mentioned composition and is excellent in plasma resistance.

Still further the present invention relates to a molded article which can be obtained by crosslinking the above-mentioned composition and has an excellent property of metal-elution inhibition, particularly relates to a sealing member for sealing of a semiconductor manufacturing equipment.

### DISCLOSURE OF INVENTION

Namely the present invention relates to the crosslinkable elastomer composition which comprises an elastomer component and a metal oxide filler containing a silicon oxide filler in an amount of not less than 60 % by weight, in which the silicon oxide filler contains impurity metals other than silicon in an amount of not more than 100 ppm.

According to the present invention, the crosslinkable elastomer composition obtained by adding a specific silicon oxide filler to a fluorine-containing elastomer component or silicone elastomer component can give a molded article having excellent mechanical properties. Further the molded article for semiconductor manufacturing equipment which is excellent in plasma resistance and has a very high cleanliness and an excellent property of metal-elution inhibition can be obtained by a special cleaning process disclosed in the above-mentioned WO99/49997, namely a process for cleaning with ultrapure water, a process for cleaning with a clean organic liquid at a cleaning temperature or with a clean inorganic aqueous solution, a dry etching cleaning process or an extractive cleaning process.

### BEST MODE FOR CARRYING OUT THE INVENTION

It is preferable that the metal oxide filler used in the present invention has a higher content of silicon oxide filler, preferably not less than 60 % by weight, further not less than 75 % by weight. It is particularly preferable that the

silicon oxide filler is used solely.

Examples of a suitable silicon oxide filler, particularly a silicon oxide filler which gives an excellent plasma resistance to a molded article are, for instance, high purity synthetic quartz, high purity synthetic silica, and the like.

Particularly a high purity synthetic quartz having quartz crystal structure is excellent in chemical resistance (for example, acid resistance). When applying a molded article produced from a fluorine-containing elastomer to the wet process by using pure water, a fluorine ion is dissociated unavoidably from the fluorine-containing elastomer. Such a dissociated fluorine ion is incorporated into the high purity synthetic quartz before released into a processing equipment. Thus the high purity synthetic quartz functions like an acid acceptor, and formation of a hydrofluoric acid can be inhibited. Examples of such a high purity synthetic quartz are, for instance, 1-FX available from Kabushiki Kaisha Tatsumori (high purity synthetic quartz spheroidal silica), and the like. Examples of the high purity synthetic silica are, for instance, SO-E1, SO-E2, SO-E3 and SO-E4 available from Kabushiki Kaisha Tatsumori, and the like.

A preferred silicon oxide filler is one which contains impurity metals other than silicon in an amount of not more than 100 ppm, preferably not more than 70 ppm, further preferably not more than 50 ppm, particularly preferably not more than 10 ppm.

An average particle size of the metal oxide of the present invention is from about 0.05 μm to about 10.0 μm, preferably from 0.1 to 5.0 μm.

It is preferable that the metal oxide filler other than the silicon oxide filler is a metal oxide containing impurity metals other than the metal of metal oxide in an amount of not more than 100 ppm, preferably not more than 50 ppm, and preferably having a pH value adjusted to 5.0 to 11.0. It is preferable that the metal of the metal oxide is at least one of titanium, cobalt, iron, aluminum, chromium, zinc, tungsten and molybdenum.

The metal oxide filler other than the silicon oxide filler which has a reduced content of impurity metals can be obtained by treating a starting metal oxide filler through extraction with an acid to reduce impurity metal contents in the metal oxide filler, and then treating the filler with alkali to neutralize the remaining acid.

As the other metal oxides which are optional components in the present invention, there are an oxide of one kind of metal, a composite metal oxide containing two or more kinds of metals and a metal hydroxide which is changeable to a metal oxide. It is preferable that a contained metal is at least one of titanium, cobalt, iron, aluminum, chromium, zinc, tungsten and molybdenum. Impurity metals to be eliminated by extraction mean those other than the metal constituting the metal oxide. It is preferable that particularly alkali metals such as sodium, potassium and lithium, copper and nickel are not contained in the filler from the viewpoint of not lowering yield of semiconductor elements.

Examples of the metal oxides are, for instance, metal oxides comprising a single metal such as $TiO_2$, $Co_3O_4$, $Al_2O_3$, $WO_3$, $Cr_2O_3$, ZnO, $MoO_3$ and $Fe_2O_3$; composite metal oxides thereof; and the like. Among them, $TiO_2$, $Al_2O_3$, $Cr_2O_3$ and ZnO are preferred from the viewpoint of excellent effect of reinforcement, and particularly preferred is $TiO_2$.

The other metal oxide filler as an optional component in the present invention is a metal oxide which contains impurity metals other than the metal of metal oxide in an amount of not more than 100 ppm, preferably not more than 70 ppm, further preferably not more than 50 ppm, particularly preferably not more than 30 ppm. A reduction of impurity metal contents may be carried out by treating a starting metal oxide with an acid such as sulfuric acid, nitric acid, hydrofluoric acid or hydrochloric acid to extract impurity metals.

In the present invention, in case where the metal oxide filler is acid, in order not to cause a crosslinking failure even if the filler is added to a crosslinkable elastomer composition, the filler is subjected to treating for neutralizing an acid which exists in the treated metal oxide and causes a failure of crosslinking with a peroxide crosslinking agent. The neutralizing treatment may be carried out with an alkali. It is preferred to avoid the use of alkali containing metals from the viewpoint of elimination of contamination sources. Examples of the preferred alkali are, for instance, an aqueous ammonia, basic amines such as triethanolamine, triethylamine and diethylamine, an ammonia gas, and the like. Particularly from the viewpoint of easy handling, separation and removal, an aqueous ammonia having a concentration of 1 to 28 % by weight is preferred. By the neutralizing treatment, a pH value which is from 2.0 to 4.0 after the acid treatment is increased to 5.0 to 11.0. A preferred pH value is from 5.0 to 9.0.

The neutralizing treatment may be carried out by dipping a filler in an alkaline solution because it is easy, or may be carried out by spraying an alkaline solution.

Further it is preferable that after the neutralizing treatment, the filler is washed with a clean chemical solution such as ultrapure water to remove a produced salt and remaining fine particles.

The neutralized washed metal oxide filler is then separated and dried. It is preferable that the drying is carried out under clean atmosphere such as a clean gas. As the clean gas, for example, high purity inert gases such as nitrogen gas, helium gas and argon gas are preferably used. It is preferable that the filler is pre-dried at 50° to 150°C for 5 to 24 hours and then heated at 200° to 300°C for 1 to 24 hours.

The neutralizing treatment may be carried out by simply cleaning with a clean chemical solution such as ultrapure water or exposing to an ammonia gas besides the above-mentioned methods. Examples of the preferred clean chemical solution to be used are ultrapure water which has a metal content of not more than 1.0 ppm and contains less than 300 fine particles of not less than 0.2 μm per 1 ml, and an organic liquid at a cleaning temperature or an

inorganic aqueous solution which has a metal content of not more than 1.0 ppm and contains less than 200 fine particles of not less than 0.5 μm per 1 ml.

The clean metal oxide filler of the present invention is added to a crosslinkable elastomer to give a crosslinkable elastomer composition. An adding amount of the filler is from 1 to 150 parts by weight (hereinafter referred to as "part"), preferably from 1 to 80 parts on the basis of 100 parts of the elastomer component. If the filler is added more, an amount of the filler to be falling away increases, which causes generation of particles.

The elastomer component is not limited particularly. When used as a starting material for a sealing member for semiconductor manufacturing equipment, a fluorine-containing elastomer or silicone elastomer is preferred.

Examples of fluorine-containing elastomer to be used preferably are elastomers capable of being crosslinked with a peroxide, imidazole, oxazole or thiazole crosslinking agent.

Examples of the fluorine-containing elastomer capable of being crosslinked with a peroxide crosslinking agent are as follows. Perfluoro elastomer comprising 40 to 90 % by mole of tetrafluoroethylene, 10 to 60 % by mole of perfluoro (vinyl ether) represented by the formula (1):

$$CF_2 = CF - OR_f$$

wherein $R_f$ is a perfluoroalkyl group having 1 to 5 carbon atoms or a perfluoroalkyl(poly)ether group having 3 to 12 carbon atoms and 1 to 3 oxygen atoms, and 0 to 5 % by mole of a monomer giving a cure site. Vinylidene fluoride elastomer comprising 30 to 90 % by mole of vinylidene fluoride, 15 to 40 % by mole of hexafluoropropylene and 0 to 30 % by mole of tetrafluoroethylene.

Thermoplastic perfluoro elastomer which is a fluorine-containing multi-segment polymer comprising an elastomeric fluorine-containing polymer chain segment and a non-elastomeric fluorine-containing polymer chain segment, in which the elastomeric fluorine-containing polymer chain segment comprises 40 to 90 % by mole of tetrafluoroethylene, 10 to 60 % by mole of perfluoro(vinyl ether) represented by the formula (1):

$$CF_2 = CF - OR_f$$

wherein $R_f$ is a perfluoroalkyl group having 1 to 5 carbon atoms or a perfluoroalkyl(poly)ether group having 3 to 12 carbon atoms and 1 to 3 oxygen atoms, and 0 to 5 % by mole of a monomer giving a cure site, and the non-elastomeric fluorine-containing polymer chain segment comprises 85 to 100 % by mole of tetrafluoroethylene and 0 to 15 % by mole of a compound represented by the formula (2):

$$CF_2 = CF - R_f^1$$

wherein $R_f^1$ is $CF_3$ or $OR_f^2$, in which $R_f^2$ is a perfluoroalkyl group having 1 to 5 carbon atoms.

Fluorine-containing multi-segment polymer comprising an elastomeric fluorine-containing polymer chain segment and a non-elastomeric fluorine-containing polymer chain segment, in which the elastomeric fluorine-containing polymer chain segment contains recurring units derived from 45 to 85 % by mole of vinylidene fluoride and from at least one other monomer copolymerizable with vinylidene fluoride. Examples of the other monomer are hexafluoropropylene, tetrafluoroethylene, chlorotrifluoroethylene, trifluoroethylene, trifluoropropylene, tetrafluoropropylene, pentafluoropropylene, trifluorobutene, tetrafluoroisobutene, perfluoro(alkyl vinyl ether), vinyl fluoride, ethylene, propylene, alkylvinylether, and the like.

Cold resistant fluorine-containing elastomer prepared by radical polymerization in the presence of a di-iodine compound and comprising 0.005 to 1.5 % by mole of iodine-containing fluorinated vinyl ether unit, 40 to 90 % by mole of vinylidene fluoride unit and 3 to 35 % by mole of perfluoro(methyl vinyl ether) unit (as case demands, hexafluoropropylene unit up to 25 % by mole and/or tetrafluoroethylene unit up to 40 % by mole may be contained) (JP-A-8-15753).

Copolymer of tetrafluoroethylene and propylene (USP-3,467,635), and the like.

As the peroxide to be used as a crosslinking agent in such peroxide crosslinking, those which have been used so far can be used. It is a matter of course that the peroxide which does not contain metal elements is preferred. Examples of the peroxide are 2,2-dimethyl-2,5-di(t-butylperoxy)hexane, and the like.

Fluorine-containing elastomers which are capable of being crosslinked with an imidazole, oxazole or thiazole crosslinking agent can provide a molded article with very high heat resistance. Examples thereof are fluorine-containing elastomers containing a tetrafluoroethylene unit and the perfluoro(vinyl ether) unit represented by the above-mentioned formula (1) and having nitrile, carboxyl and/or alkoxycarbonyl as a crosslinkable group.

Examples of perfluoro(vinyl ether) are perfluoro(methyl vinyl ether) (PMVE), perfluoro(ethyl vinyl ether) (PEVE), perfluoro(propyl vinyl ether) (PPVE), and the like. Among them, PMVE is preferred.

A proportion of the tetrafluoroethylene unit to the perfluoro(vinyl ether) unit is 40 to 90/60 to 10 in % by mole.

Examples of the crosslinkable group which gives reactivity for crosslinking to the fluorine-containing elastomer capable of being crosslinked with an imidazole, oxazole or thiazole crosslinking agent are nitrile, carboxyl and/or alkoxycarbonyl. Examples of alkoxycarbonyl are methoxycarbonyl, ethoxycarbonyl, propoxycarbonyl, and the like. A content of the crosslinkable group is not more than 5 % by mole, preferably not more than 2 % by mole.

Examples of the method to introduce such crosslinkable group are a method of copolymerizing a monomer having a crosslinkable group or a group convertible to a crosslinkable group (copolymerizing method), a method of converting a polymerization initiating moiety of polymerization end to carboxyl (end group converting method), and the like.

Examples of the monomer to be used for the copolymerizing method are a nitrile-containing monomer, carboxyl-containing monomer, alkoxycarbonyl-containing monomer, and the like represented by:

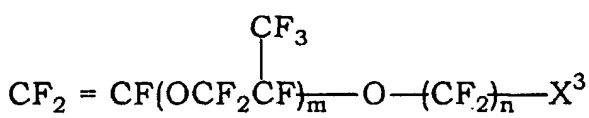

wherein m is 0 to 5 and n is 1 to 8,

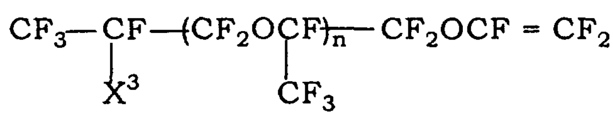

wherein n is 1 to 4,

$$CF_2 = CFO(CF_2)_n\text{—}OCF(CF_3)X^3$$

wherein n is 2 to 5,

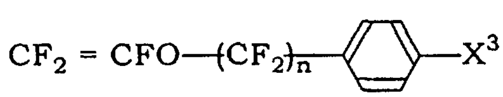

wherein n is 1 to 6,

$$CF_2 = CF[OCF_2CF(CF_3)]_nOCF_2CF(CF_3)X^3$$

wherein n is 1 or 2, and

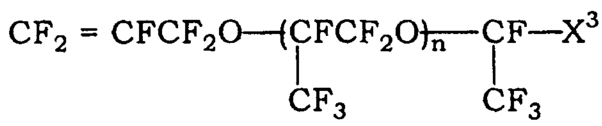

wherein $X^3$ is CN, COOH or $COOR^5$, in which $R^5$ is alkyl which may contain fluorine atom having 1 to 10 carbon atoms.

In case where at least one of end groups is carboxyl or alkoxycarbonyl, it is preferable to copolymerize a monomer having nitrile or carboxyl from the viewpoint of crosslinking reactivity.

As a crosslinking agent to be used for the imidazole crosslinking, oxazole crosslinking or thiazole crosslinking, it is preferable to use a compound having at least two amino groups. Particularly from the viewpoint of enhancing heat resistance, preferred is a compound having at least two functional groups represented by the formula (I):

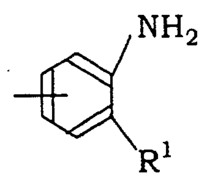

wherein $R^1$ is any one of OH, $NH_2$ or SH.

Examples of the compound represented by the formula (I) are compounds represented by the formula (II):

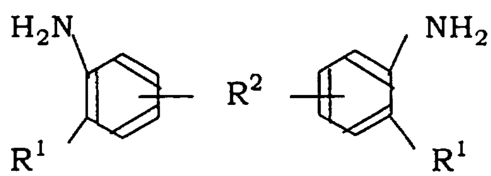

wherein $R^1$ is as defined above, $R^2$ is $-SO_2-$, -O-, -CO-, alkylene having 1 to 6 carbon atoms, perfluoroalkylene having 1 to 10 carbon atoms, a single bond or a group represented by the formula (III).

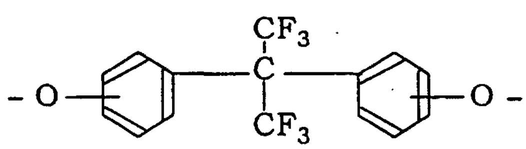

Positions of $NH_2$ and $R^1$ to phenyl group may be the same or different at both sides of the right and left functional groups (I).

Non-restricted examples of preferred alkylene of $R^2$ which may be substituted are, for instance, non-substituted alkylene having 1 to 6 carbon atoms, perfluoroalkylene having 1 to 10 carbon atoms, and the like. Examples of perfluoroalkylene are:

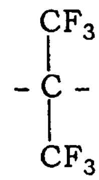

and the like. Those $R^2$ are known as a bisdiaminophenyl compound raised in JP-B-2-59177 and JP-A-8-120146.

Though $R^2$ may be bonded to any positions of the both right and left benzene rings, it is preferable that either of $NH_2$ group or $R^1$ is so bonded as to be at a para position from the viewpoint of easy synthesis and advancing a crosslinking reaction easily.

Non-restricted examples of the crosslinking agent are, for instance, bisdiaminophenyl compound (for imidazole crosslinking) such as 2,2-bis-(3,4-diaminophenyl)hexafluoropropane, bis-(3,4-diaminophenyl)methane and bis-(3,4-diaminophenyl)ether; bisaminophenol compounds (for oxazole crosslinking) such as 2,2-bis-(3-amino-4-hydroxyphenyl)hexafluoropropane (generally called bis(aminophenol)AF);
bisaminothiophenol compound (for thiazole crosslinking) such as 2,2-bis-(3-amino-4-mercaptophenyl)hexafluoropropane; and the like.

Those crosslinking agents give molded articles being excellent in mechanical strength, heat resistance and chemical resistance, particularly having well-balanced heat resistance and chemical resistance.

Examples of the preferred silicone elastomer are, for instance, a silicone rubber, fluoro silicone rubber, and the like.

The elastomer composition can be crosslinked into products having desired forms. As a crosslinking method, though the above-mentioned crosslinking with a peroxide, imidazole, oxazole or thiazole crosslinking agent is preferable, other known crosslinking methods, for example, methods of crosslinking with a triazine, polyol and polyamine crosslinking agents, methods of crosslinking by irradiating radioactive rays and electron beams, and the like may be employed.

The crosslinking agent is added in an amount of from 0.05 to 10 parts (part by weight, hereinafter the same), preferably from 0.1 to 2.0 parts on the basis of 100 parts of the elastomer component and if necessary, the crosslinking accelerator is added in an amount of from 0.1 to 10 parts, preferably from 0.3 to 5.0 parts on the basis of 100 parts of the elastomer component. In addition, a processing aid, internal mold releasing agent, and the like may be added in an amount not lowering effect of the present invention.

The crosslinkable elastomer composition of the present invention can be suitably used for production of a molded article for semiconductor manufacturing equipment, particularly a sealing member for sealing of semiconductor manufacturing equipment which is particularly required to be highly clean. Examples of the sealing member are O-ring, square ring, gasket, packing, oil seal, bearing seal, lip type seal, and the like.

In addition, the crosslinkable elastomer composition can be used for a variety of elastomer products, for example, diaphragm, tube, hose, various rubber rolls, and the like. Also the composition can be used as a coating material and a lining material.

The molded article of the present invention is suitable for a sealing member for sealing of a semiconductor manufacturing equipment used in a dry process such as a plasma etching equipment mentioned hereinafter and also a sealing member for sealing of a semiconductor manufacturing equipment used in a wet process such as a cleaning equipment since elution of metals can be reduced.

With respect to the molded article suitable for dry process, an impurity metal content measured by an ashing analysis method is not more than 100 ppm, preferably not more than 50 ppm, and an increasing rate of particles generated by irradiating oxygen plasma is not more than 1,000 %, preferably not more than 500 %, more preferably not more than 200 %. It is preferable that the number of particles increased by irradiating oxygen plasma is not more than $50 \times 10^4/cm^2$.

With respect to the molded article suitable for wet process, an amount of impurity metals extracted with $H_2SO_4/H_2O_2$ (4/1 in weight ratio) is such that a total amount of Fe and Na does not exceed 8 ppb and that an amount of impurity metals other than silicon which is extracted with a 50 % aqueous solution of HF is not more than 200 ppb, preferably not more than 100 ppb.

In the present invention, the semiconductor manufacturing equipment is not limited to equipment for manufacturing semiconductors and encompasses whole manufacturing equipment used in the field of semiconductors where a high degree of cleanliness is required, such as equipment for manufacturing a liquid crystal panel and plasma panel.

Examples of the semiconductor manufacturing equipment are as follows.

(1) Etching system
- Dry etching equipment (for dry process)
  - Plasma etching machine (for dry process)
  - Reactive ion etching machine (for dry process)
  - Reactive ion beam etching machine (for dry process)
  - Sputter etching machine (for dry process)
  - Ion beam etching machine (for dry process)
- Wet etching equipment (for wet process)
- Ashing equipment (for dry process)

(2) Cleaning system
- Dry etching cleaning equipment (for dry process)
  - UV/$O_3$ cleaning machine (for dry process)
  - Ion beam cleaning machine (for dry process)
  - Laser beam cleaning machine (for dry process)
  - Plasma cleaning machine (for dry process)
  - Gas etching cleaning machine (for dry process)
- Extractive cleaning equipment
  - Soxhlet extractive cleaning machine (for wet process)
  - High temperature high pressure extractive cleaning machine (for wet process)
  - Microwave extractive cleaning machine (for wet process)
  - Supercritical extractive cleaning machine (for wet process)

(3) Exposing system
- Stepper (for wet process)
- Coater and developer (for wet process)

(4) Polishing system
- CMP equipment (for wet process)

(5) Film forming system
- CVD equipment (for dry process)
- Sputtering equipment (for dry process)

(6) Diffusion and ion implantation system
- Oxidation and diffusion equipment (for dry process)
- Ion implantation equipment (for dry process)

(7) Cleaning system using hydrofluoric acid, hydrochloric acid, sulfuric acid, aqueous ozone, and the like (for wet process)

The present invention is then explained by means of examples, but is not limited to them.

Contents of impurity metals in the silicon oxide fillers which were used in the following examples and comparative examples are shown in Table 1.

(Contents of impurity metals in filler)

0.1 Gram of a silicon oxide filler is put in a platinum crucible, and after diffused and dissolved in 5 ml of 50 % hydrofluoric acid in a hot bath, is diluted with ultrapure water. Contents of metals of that solution were determined through atomic absorption analysis by using an atomic absorption photometer (Z8000 available from Hitachi, Ltd.). Metals intended to detect were metals shown in Table 1. Contents of each metal in the filler were determined by the following equation.

$$\text{Metal content (ppm)} = \frac{\text{Concentration in solution (ppm)}}{\text{Weight of filler (g)}} \times \text{Weight of solution (g)}$$

EXAMPLE 1

A 6-liter stainless steel autoclave provided with no ignition source was charged with 2 liters of pure water, 20 g of $C_7F_{15}COONH_4$ as an emulsifying agent and 0.18 g of disodium hydrogen phosphate·$12H_2O$ as a pH regulator. After the inside of the system was replaced with nitrogen gas sufficiently for deaeration, the autoclave was heated to 50°C with stirring at 600 rpm, and a mixed gas of tetrafluoroethylene (TFE) and perfluoro(methyl vinyl ether) (PMVE) (TFE/PMVE=20/80 in mole ratio) was fed so that the inside pressure became 1.18 MPa·G. Then 2 ml of an aqueous solution containing ammonium persulfate (APS) in a concentration of 186 mg/ml was fed with pressurized nitrogen to

initiate a reaction.

With advance of the polymerization, at the time when the inside pressure lowered to 1.08 MPa·G, 4.0 g of diiodine compound $I(CF_2)_4I$ was fed with pressurized nitrogen. Then a mixture gas of TFE and PMVE (mole ratio of 19/23) was fed under pressure by a plunger pump. After that, increasing and decreasing of the pressure were repeated between 1.08 MPa·G and 1.18 MPa·G.

At the time when a total feeding amount of TFE and PMVE reached 430 g, 511 g and 596 g, respectively, 1.5 g of $ICH_2CF_2CF_2OCF=CF_2$ was fed under pressure. Also every 12 hours after the initiation of the polymerization reaction, 2 ml of an aqueous solution containing ammonium persulfate (APS) in a concentration of 35 mg/ml was fed with pressurized nitrogen to continue the polymerization reaction. The polymerization was terminated 35 hours after the initiation of the reaction.

The obtained aqueous emulsion was frozen in dry ice/methanol to be coagulated, and then after thawing, a precipitated product was washed with water and vacuum-dried to give an elastomeric copolymer. A Mooney viscosity $ML_{1+10}$ (100°C) of the copolymer was 63.

As a result of $^{19}F$-NMR analysis, monomer units of the copolymer were TFE/PMVE=59.2/40.8 in % by mole, and an iodine content obtained by elementary analysis was 0.03 % by weight.

An elastomer composition of the present invention was prepared by kneading 10 g of 1-FX (High purity synthetic quartz spheroidal silica available from Kabushiki Kaisha Tatsumori, average particle size: 0.38μm), 0.5 g of 2,5-dimethyl-di(t-butylperoxy)hexane (Perhexa 2.5B available from NOF Corporation) and 2.0 g of triallylisocyanurate (TAIC) (available from Nippon Kasei Kabushiki Kaisha) with 100 g of the obtained tetrafluoroethylene/perfluoro(alkyl vinyl ether) copolymer elastomer. The composition was crosslinked with a hot press (primary crosslinking) by compression-molding at 160°C for 10 minutes, and then crosslinked in an oven (secondary crosslinking) at 180°C for four hours to give an O-ring (AS-568A-214).

The obtained O-ring was cleaned with sufficiently much amount of $H_2SO_4/H_2O_2$ (4/1 in weight ratio) mixture solution at 100°C for 30 minutes with stirring and after rinsing with pure water, was dried under clean environment to give a sample O-ring.

With respect to the obtained O-ring, the number of particles was measured by the method mentioned below.

(Number of particles)

The sample was cleaned with a supersonic wave in ultrapure water at 25°C for one hour, and then the number of particles having a particle size of not less than 0.2 μm was measured by a fine particle meter method (a method of emitting light to ultrapure water containing particles which was flowed into a sensor part and then electrically measuring amounts of transmitted light and scattered light with a submerged particle counter (available from Kabushiki Kaisha Rion)).

$$\text{Number of particles released from O-ring } (/\text{cm}^2) = \frac{\left(\dfrac{\text{Total amount of ultrapure water (ml)}}{\text{Amount of pure water sampled in particle counter}}\right) \times \left(\text{Number of particles per one O-ring}\right)}{\text{Surface area per one O-ring (AS-568A-214) } (/\text{cm}^2)}$$

Subsequently plasma resistance test of the above-mentioned O-ring after washing was carried out by the method mentioned below to measure the number of particles after plasma irradiation to the O-ring. The results are shown in Table 2 together with an increasing rate of particles and a change in weight after the plasma irradiation.

(Plasma resistance test)

Plasma was generated under the conditions of a vacuum pressure of 50 mTorr, an oxygen flow of 200 cc/min, electric power of 400 W and a frequency of 13.56 MHz by using Plasma Dry Cleaner Model PX-1000 available from Kabushiki Kaisha Samco International Kenkyusho, and the generated plasma was irradiated to a sample (O-ring) under the reactive ion etching (RIE) conditions for three hours.

Then amount of impurity metals extracted from the obtained O-ring was determined by the method mentioned below. The results are shown in Table 3 (extraction in $H_2SO_4/H_2O_2$ (4/1 in weight ratio)) and Table 4 (extraction in 50 % HF).

(Metal extraction test)

(1) A vessel (with a lid) made of tetrafluoroethylene/perfluoro(alkyl vinyl ether) copolymer (so-called PFA) and sufficiently cleaned previously is charged with a given amount of chemical solution for extraction.
(2) The chemical solutions to be used are $H_2SO_4/H_2O_2$ (4/1) mixture and a 50 % aqueous solution of HF. Both chemical solutions to be used are those having a grade for use in production of semiconductors.
(3) The obtained O-ring is cleaned with sufficiently much amount of $H_2SO_4/H_2O_2$ (4/1 in weight ratio) mixture solution at 100°C for 30 minutes with stirring and after rinsing with pure water, is dried under clean environment to give a sample O-ring. The sample O-rings are dipped in the respective chemical solutions and after sealing, both solutions are kept at a given temperature for a given period of time (at 25°C for 14 days in case of $H_2SO_4/H_2O_2$ (4/1) mixture and 25°C for 24 hours in case of a 50 % aqueous solution of HF). In that case, extraction of metals is compared with control solutions stored without dipping the samples therein.
(4) After storing the solutions for the above-mentioned period of time, concentrations of metals in the solutions were measured with ICP-MS (SPQ9000 available from Seiko Denshi Kabushiki Kaisha) in case of $H_2SO_4/H_2O_2$ (4/1) mixture and with an atomic absorption photometer (Z-8000 available from Hitachi, Ltd.) in case of a 50 % aqueous solution of HF.
(5) Amounts of metals extracted from the O-ring were calculated by the following equation.

$$\text{Amount of extracted metal (ppb)} = \frac{\begin{pmatrix}\text{Metal concentration}\\ \text{in chemical solution}\\ \text{(ppb)}\end{pmatrix} - \begin{pmatrix}\text{Metal concentration}\\ \text{in control solution}\\ \text{(ppb)}\end{pmatrix}}{\text{Weight of O-ring (g)}} \times \text{Weight of chemical solution (g)}$$

Further with respect to the obtained O-ring, contents of impurity metals were determined by the method mentioned below. The results are shown in Table 5.

(Contents of impurity metals)

0.5 To 2.0 grams of sample O-ring is put in a clean platinum crucible, and heated at 600°C for two hours to be sufficiently ashed. Then 5 ml of 5 % by weight of hydrofluoric acid is added to the ash remaining in the crucible and heated and dissolved in a hot bath, followed by diluting with ultrapure water. Contents of metals of that solution were determined through atomic absorption analysis by using an atomic absorption photometer (Z8000 available from Hitachi, Ltd.). Metals intended to detect were metals shown in Table 1. Contents of each metal in the O-ring were determined by the following equation.

$$\text{Metal content (ppm)} = \frac{\text{Concentration in solution (ppm)}}{\text{Weight of O-ring (g)}} \times \text{Weight of solution (g)}$$

COMPARATIVE EXAMPLE 1

An elastomer composition for comparison was prepared in the same manner as in Example 1 except that 10 g of high grade titanium oxide filler (TM-1 available from Fuji Titanium Industry Co., Ltd.) was used as a metal oxide filler instead of 1-FX. The composition was crosslinked in the same manner as in Example 1 to give an O-ring.
The number of particles before and after oxygen plasma resistance test of the O-ring was determined. The results are shown in Table 2.

COMPARATIVE EXAMPLE 2

An elastomer composition for comparison was prepared in the same manner as in Example 1 except that a mixture of 5 g of high grade titanium oxide filler (TM-1 available from Fuji Titanium Industry Co., Ltd.) and 5 g of 1-FX was used as a metal oxide filler instead of 1-FX. The composition was crosslinked in the same manner as in Example 1 to give an O-ring.
The number of particles before and after oxygen plasma resistance test of the O-ring was determined. The

results are shown in Table 2.

COMPARATIVE EXAMPLE 3

An elastomer composition for comparison was prepared in the same manner as in Example 1 except that 10 g of white carbon filler by wet process (CARPLEX #1120 available from Shionogi Seiyaku Kabushiki Kaisha) was used as a metal oxide filler instead of 1-FX. The composition was crosslinked in the same manner as in Example 1 to give an O-ring.

Amounts of extracted impurity metals of the O-ring were measured in the same manner as in Example 1. The results are shown in Table 3 (extraction in $H_2SO_4/H_2O_2$ (4/1)) and Table 4 (extraction in 50 % HF).

Further impurity metal contents of the obtained O-ring were determined in the same manner as in the above-mentioned method of O-ring. The results are shown in Table 5.

EXAMPLE 2

A 3-liter stainless steel autoclave provided with no ignition source was charged with 1 liter of pure water, 10 g of:

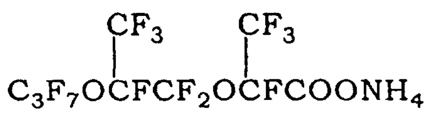

as an emulsifying agent and 0.09 g of disodium hydrogen phosphate·$12H_2O$ as a pH regulator. After the inside of the system was replaced with nitrogen gas sufficiently for deaeration, the autoclave was heated to 50°C with stirring at 600 rpm, and a mixed gas of tetrafluoroethylene (TFE) and perfluoro(methyl vinyl ether) (PMVE) (TFE/PMVE=25/75 in mole ratio) was fed so that the inside pressure became 0.78 MPa·G. Then 10 ml of an aqueous solution containing ammonium persulfate (APS) in a concentration of 527 mg/ml was fed with pressurized nitrogen to initiate a reaction.

With advance of the polymerization, at the time when the inside pressure lowered to 0.69 MPa·G, 1.89 g of $CF_2$=$CFOCF_2CF(CF_3)OCF_2CF_2COOH$ (CBVE) was fed with pressurized nitrogen. Then 4.7 g of TFE and 5.3 g of PMVE were fed with their self-pressures. After that, with the advance of the reaction, TFE and PMVE were fed under pressure in the same manner, and increasing and decreasing of the pressure were repeated between 0.78 MPa·G and 0.69 MPa·G. At the time when a total feeding amount of TFE and PMVE reached 80 g 4.2 hours after the initiation of the polymerization reaction, the autoclave was cooled and an un-reacted monomer was released to give 1,089 g of an aqueous dispersion having a solid content of 7.5 % by weight.

Then 1,000 g of the aqueous dispersion was diluted with 3,000 g of water and slowly added to 2,800 g of aqueous solution of 3.5 % by weight of hydrochloric acid with stirring. After the addition, the solution was stirred for five minutes and a precipitated product was filtrated. The obtained polymer was further added to 800 g of HCFC-141b, stirred for five minutes and then filtrated again. After that, the steps of washing with HCFC-141b and filtrating were repeated four times, followed by vacuum-drying at 120°C for 72 hours to give an elastomeric copolymer.

As a result of $^{19}F$-NMR analysis, monomer units of the copolymer were TFE/PMVE/CBVE=59.6/39.9/0.5 in % by mole.

An elastomer composition of the present invention was prepared by kneading 10 g of 1-FX (high purity synthetic quartz spheroidal silica) and 2.0 g of 2,2-bis(3,4-diaminophenyl)hexafluoropropane with 100 g of the obtained tetrafluoroethylene/perfluoro(alkyl vinyl ether) copolymer elastomer. The composition was crosslinked with a hot press (primary crosslinking) by compression-molding at 200°C for 30 minutes, followed by crosslinking in an oven (secondary crosslinking) at 204°C for 18 hours and then at 288°C for 18 hours to give an O-ring (AS-568A-214).

With respect to the obtained O-ring, the number of particles before and after the oxygen plasma resistance test was determined in the same manner as in Example 1. The results are shown in Table 2.

TABLE 1

| | Content (ppm) | | |
|---|---|---|---|
| Impurity metal | High purity synthetic quartz spheroidal silica Ex. 1 and 2 | White carbon by wet process Com. Ex. 3 | Detection limit (ppm) |
| Na | 2 | 27000 | 0.002 |
| K | 0.4 | 800 | 0.03 |

TABLE 1 (continued)

| | Content (ppm) | | |
|---|---|---|---|
| Impurity metal | High purity synthetic quartz spheroidal silica Ex. 1 and 2 | White carbon by wet process Com. Ex. 3 | Detection limit (ppm) |
| Ca | 2 | 100 | 0.03 |
| Fe | 1 | 2 | 0.04 |
| Ni | 0.1 | 9 | 0.05 |
| Cu | 1 | 1 | 0.01 |
| Cr | 0.2 | 1 | 0.01 |
| Mg | 2 | 3 | 0.005 |
| Total | 8.7 | 27916 | - |

TABLE 2

| Number of particles ($\times 10^4/cm^2$) | Ex. 1 | Ex. 2 | Com. Ex. 1 | Com. Ex. 2 |
|---|---|---|---|---|
| Before plasma irradiation (A) | 0.9 | 0.9 | 0.9 | 0.9 |
| After plasma irradiation (B) | 2.3 | 2.1 | 17.8 | 17.3 |
| Number of increased particles (C=B-A) | 1.4 | 1.2 | 16.9 | 16.4 |
| Increasing rate (C/A × 100) (%) | 156 | 133 | 1878 | 1822 |

TABLE 3

| Extracted amount (ppb) | | | |
|---|---|---|---|
| Impurity metal | Ex. 1 (High purity synthetic quartz spheroidal silica) | Com. Ex. 3 (White carbon by wet process) | Detection limit (ppb) |
| Fe | ND | 10 | 5 |
| Ni | ND | ND | 3 |
| Cu | ND | ND | 1 |
| Na | ND | 9 | 3 |
| K | ND | ND | 4 |
| Ca | ND | ND | 1 |
| Mg | ND | ND | 1 |
| Zn | ND | ND | 1 |
| Total | ND | 19 | - |

TABLE 4

| | Extracted amount (ppb) | | |
|---|---|---|---|
| Impurity metal | Ex. 1 (High purity synthetic quartz spheroidal silica) | Com. Ex. 3 (White carbon by wet process) | Detection limit (ppb) |
| Fe | 10 | 80 | 1 |
| Ni | ND | 20 | 3 |
| Cu | ND | 1 | 1 |
| Na | 5 | 1000 | 0.5 |
| K | 3 | 40 | 0.5 |
| Ca | 5 | 20 | 1 |
| Mg | 20 | 30 | 0.4 |
| Zn | 20 | 50 | 1 |

TABLE 4 (continued)

| | Extracted amount (ppb) | | |
|---|---|---|---|
| Impurity metal | Ex. 1 (High purity synthetic quartz spheroidal silica) | Com. Ex. 3 (White carbon by wet process) | Detection limit (ppb) |
| Total | 63 | 1241 | - |

TABLE 5

| Content (ppm) | | | |
|---|---|---|---|
| Impurity metal | Ex. 1 (High purity synthetic quartz spheroidal silica) | Com. Ex. 3 (White carbon by wet process) | Detection limit (ppm) |
| Na | 1 | 300 | 0.002 |
| K | 3 | 30 | 0.009 |
| Ca | 0.7 | 20 | 0.006 |
| Mg | 0.3 | 20 | 0.002 |
| Fe | 0.7 | 30 | 0.004 |
| Ni | 0.1 | 1 | 0.005 |
| Cu | 0.4 | 6 | 0.002 |
| Cr | 2 | 2 | 0.003 |
| Total | 8.2 | 409 | - |

INDUSTRIAL APPLICABILITY

The metal oxide filler mainly comprising a silicon oxide of the present invention can give an elastomer molded article which is very clean and excellent in plasma resistance, has an excellent property of metal-elution inhibition and is used suitably as a material for molded article for a semiconductor manufacturing equipment.

**Claims**

1. A crosslinkable elastomer composition which comprises a crosslinkable elastomer component and a metal oxide filler containing a silicon oxide filler in an amount of not less than 60 % by weight; said silicon oxide filler has a content of impurity metals other than silicon of not more than 100 ppm.

2. The crosslinkable elastomer composition of Claim 1, wherein said metal oxide filler consists of the silicon oxide filler.

3. The crosslinkable elastomer composition of Claim 1 or 2, wherein said silicon oxide filler has quartz crystal structure.

4. The crosslinkable elastomer composition of any of Claims 1 to 3, wherein said silicon oxide filler is blended in an amount of from 1 to 150 parts by weight on the basis of 100 parts by weight of the elastomer component.

5. The crosslinkable elastomer composition of any of Claims 1 to 4, which contains a crosslinking agent and said silicon oxide filler in amounts of 0.05 to 10 parts by weight and 1 to 150 parts by weight, respectively on the basis of 100 parts by weight of the elastomer component.

6. The crosslinkable elastomer composition of any of Claims 1 to 5, wherein the elastomer component is a fluorine-containing elastomer or a silicone elastomer.

7. The crosslinkable elastomer composition of Claim 6, wherein the elastomer component is a fluorine-containing elastomer capable of being crosslinked with a peroxide crosslinking agent.

8. The crosslinkable elastomer composition of Claim 6, wherein the elastomer component is a fluorine-containing

elastomer capable of being crosslinked with an imidazole, oxazole, thiazole or triazine crosslinking agent.

**9.** The crosslinkable elastomer composition of Claim 6 or 7, wherein the crosslinking agent is an organic peroxide.

**10.** The crosslinkable elastomer composition of Claim 6 or 8, wherein the crosslinking agent is a compound having at least two functional groups represented by the formula (I):

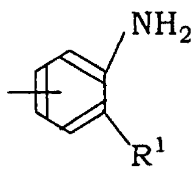

wherein $R^1$ is any one of OH, $NH_2$ or SH.

**11.** A molded article obtained by crosslinking the elastomer composition of any of Claims 1 to 10.

**12.** The molded article of Claim 11, wherein an increasing rate of particles generated by irradiating oxygen plasma to the article is not more than 1,000 %.

**13.** The molded article of Claim 11, wherein an amount of impurity metals other than silicon which are extracted with a 50 % aqueous solution of HF is not more than 200 ppb.

**14.** The molded article of Claim 11, which contains impurity metals other than silicon in an amount of not more than 100 ppm.

**15.** The molded article of any of Claims 11 to 14, wherein the article is used for a semiconductor manufacturing equipment.

**16.** The molded article of Claim 15, wherein the article is a sealing member used for sealing of a semiconductor manufacturing equipment.

**17.** The molded article of Claim 13, wherein the article is a sealing member used for sealing of a semiconductor manufacturing equipment for wet process.

**18.** The molded article of Claim 17, wherein the article is a sealing member used for sealing of a semiconductor manufacturing equipment for a process with ultrapure water.

## INTERNATIONAL SEARCH REPORT

International application No.
PCT/JP00/00055

A. CLASSIFICATION OF SUBJECT MATTER
Int.Cl$^7$ C08L21/00, C08L83/04, C08L15/02, C08L27/12, C08K3/22, C08K3/36, H01L23/29

According to International Patent Classification (IPC) or to both national classification and IPC

B. FIELDS SEARCHED
Minimum documentation searched (classification system followed by classification symbols)
Int.Cl$^7$ C08L21/00, C08L83/04, C08L15/02, C08L27/12, C08K3/22, C08K3/36, H01L23/29

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| | EP, 496419, A2 (Shin-Etsu Chemical Co., Ltd.), 29 July, 1992 (29.07.92), | |
| X | Claims; page 2, line 58 to page 3, line 2 | 1-18 |
| Y | Claims; page 2, line 58 to page 3, line 2 & JP, 5-105814, A Claims; Par. No. 0043 & US, 5276087, A & DE, 69223659, C3 | 1-18 |
| Y | US, 5194479, A (Shin-Etsu Chemical Co., Ltd.), 16 March, 1993 (16.03.93), Claims; Column 3, lines 7 to 12 & JP, 3-281572, A Claims; page 3, upper left column, lines 9 to 14 & EP, 449651, A1 & DE, 69103307, C3 | 1-18 |
| Y | JP, 7-188387, A (Toshiba Chemical Corporation), 25 July, 1995 (25.07.95), Claims; Par. Nos. [0014] to [0016] (Family: none) | 1-18 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 March, 2000 (22.03.00) | 04 April, 2000 (04.04.00) |
| Name and mailing address of the ISA/ Japanese Patent Office | Authorized officer |
| Facsimile No. | Telephone No. |

Form PCT/ISA/210 (second sheet) (July 1992)